# EUROPEAN PATENT APPLICATION

(11) **EP 4 557 925 A1**
(43) Date of publication of application: **21.05.2025**
(21) Application number: 22755061.3
(22) Date of filing: 22.07.2022
(51) Int. Cl.: H10K 71/00, H10K 50/80, H10K 59/00

(54) **DISPLAY PANEL AND METHOD FOR MANUFACTURING DISPLAY PANEL**

(30) Priority: 15.07.2022 CN 202210835770
(71) Applicant: Shenzhen China Star Optoelectronics Semiconductor Display Technology Co., Ltd., Shenzhen, Guangdong 518132 (CN)
(72) Inventor: WU, Fanjing, Shenzhen, Guangdong 518132 (CN); HU, Jingyuan, Shenzhen, Guangdong 518132 (CN)
(74) Representative: Murgitroyd & Company
(86) International application number: PCT/CN2022/107457
(87) International publication number: WO 2024/011655

(57) **Abstract**

A display panel and a method of manufacturing the display panel are provided in the present application. An auxiliary cathode is disposed in the driving circuit layer of the display panel, at the same time, a strapping hole is disposed on the auxiliary cathode. The cathode layer can extend into the strapping hole and contact with a conductive structure. Therefore, a voltage drop can be improved.

## Description

### FIELD OF INVENTION

The present application relates to a field of display technology, and in particular, to a display panel and a method of manufacturing a display panel.

### BACKGROUND OF INVENTION

Organic light-emitting diode (OLED) display panels have the advantages of display characteristics and quality beyond LCD, such as light weight, short response time, low driving voltage, better display color, and display viewing angle, etc. It has received extensive attention from everyone. In recent years, its development has changed rapidly. It can not only produce curved display, but also gradually develop to large size.

Large-size OLED display panels are more urgent to solve a problem of voltage drop due to their larger size and thinner cathodes, especially for top-emission panels, which are prone to visible Mura, that is, uneven display. Currently, an auxiliary electrode and a cathode layer are often connected in parallel to improve the voltage drop phenomenon. Generally, an inverted trapezoidal isolation column is disposed between the cathode and the auxiliary electrode. However, a volume of the isolation column is large and a molding difficulty is high, which affects an aperture ratio and encapsulating, and a selectivity of raw material is less, which makes a manufacturing process more complicated and reduces a production efficiency and a product yield.

In summary, the currently display panel has a problem that a manufacturing process of the auxiliary cathode is complicated. Therefore, it is necessary to provide a display panel and a method of manufacturing the display panel to improve the above-mentioned problem.

### SUMMARY OF INVENTION

The embodiment of the present application provides a display panel and a method of manufacturing the same, which can improve a voltage drop phenomenon, improve a display uniformity of the display panel, avoid the manufacture of spacers, reduce a difficulty of the manufacturing process, and improve a production efficiency.

Embodiments of the present application provide a display panel, including:
a substrate;
a driving circuit layer disposed on the substrate, wherein an auxiliary electrode is disposed in the driving circuit layer;
a common layer disposed on a side of the driving circuit layer away from the substrate; and
a cathode layer disposed on a side of the common layer away from the driving circuit layer;
wherein the auxiliary electrode includes a multi-layer stacking conductive structure, wherein the auxiliary electrode is provided with a strapping hole, wherein the common layer is disconnected at the strapping hole, and wherein the cathode layer extends into the strapping hole and in contact with a side of the conductive structure close to the substrate.

According to one embodiment of the present application, the auxiliary electrode includes:
a first conductive structure;
a second conductive structure disposed on a side of the first conductive structure close to the substrate; and
a third conductive structure disposed on a side of the second conductive structure close to the substrate;
the strapping hole includes a first opening disposed in the first conductive structure and a second opening disposed in the second conductive structure;
wherein the common layer is disconnected at the first opening, and wherein the cathode layer is continuously arranged at the first opening and the second opening, and extends into the second opening and in contact with the third conductive structure.

According to one embodiment of the present application, a size of the first opening is smaller than a size of the second opening.

According to one embodiment of the present application, the strapping hole includes a third opening disposed in the third conductive structure, wherein a size of the third opening is smaller than the size of the second opening.

According to one embodiment of the present application, an inner periphery of the first conductive structure protrudes from an inner periphery of the second conductive structure, wherein an inner periphery of the third conductive structure protrudes from the inner periphery of the second conductive structure.

According to one embodiment of the present application, the first conductive structure includes a first protrusion protruding from the inner periphery of the second conductive structure, wherein the third conductive structure includes a second protrusion protruding from the inner periphery of the second conductive structure, wherein an undercut space is formed between the first protrusion, the second protrusion, and an inner sidewall of the second conductive structure, and wherein the cathode layer extends into the undercut space and is in contact with the second protrusion.

According to one embodiment of the present application, the driving circuit layer includes a source-drain electrode layer, wherein the source-drain electrode layer includes a source electrode and a drain electrode, and wherein the auxiliary electrode and the source-drain electrode layer are set on a same layer.

According to one embodiment of the present application, the driving circuit layer includes a protective layer and a planarization layer, wherein the protective layer is disposed on a side of the auxiliary electrode away from the substrate, and wherein the planarization layer is disposed on a side of the protective layer away from the auxiliary electrode;
wherein the driving circuit layer is provided with an auxiliary strapping hole, and wherein the auxiliary strapping hole penetrates the planarization layer and the protective layer, and exposes the auxiliary electrode.

According to one embodiment of the present application, the driving circuit layer includes a source-drain electrode layer, wherein the source-drain electrode layer includes a source electrode and a drain electrode, and wherein the auxiliary electrode is disposed on a side of the source-drain electrode layer away from the substrate.

According to one embodiment of the present application, the driving circuit layer includes a protective layer and a planarization layer, wherein the protective layer is disposed on a side of the auxiliary electrode away from the substrate, and wherein the planarization layer is disposed on a side of the protective layer away from the auxiliary electrode;
wherein the driving circuit layer is provided with an auxiliary strapping hole, and wherein the auxiliary strapping hole penetrates the planarization layer and the protective layer, and exposes the auxiliary electrode.

According to one embodiment of the present application, an activity of the first conductive structure is weaker than an activity of the second conductive structure, and wherein an activity of the third conductive structure is weaker than the activity of the second conductive structure.

According to one embodiment of the present application, the first conductive structure is made of a same material as the third conductive structure, wherein a material of the first conductive structure includes metal alloy, and wherein a material of the second conductive structure is made of metal.

According to one embodiment of the present application, a material of the first conductive structure is molybdenum titanium alloy, and wherein a material of the second conductive structure is copper or aluminum.

According to the display panel provided by the above embodiments of the present application, the embodiment of the present application also provides a method of manufacturing a display panel, including:
forming a driving circuit layer on the substrate, wherein an auxiliary electrode is disposed in the driving circuit layer, and wherein the auxiliary electrode includes a multi-layer stacking conductive structure;
forming a strapping hole on the auxiliary electrode;
forming a common layer on a side of the driving circuit layer away from the substrate, wherein the common layer is disconnected at the strapping hole; and
forming a cathode layer on a side of the common layer facing away from the driving circuit layer, wherein the cathode layer extends into the strapping hole and is in contact with a side of the conductive structure close to the substrate.

According to one embodiment of the present application, the step of forming the driving circuit layer on the substrate, wherein the auxiliary electrode is disposed in the driving circuit layer, and wherein the auxiliary electrode includes the multi-layer stacking conductive structure further includes:
forming a source-drain electrode layer on the substrate, wherein the source-drain electrode layer includes a first conductive layer, a second conductive layer, and a third conductive layer stacked on the substrate in sequence;
patterning the source-drain electrode layer to form a source electrode, a drain electrode, and the auxiliary electrode, wherein the auxiliary electrode is formed with an initial strapping hole penetrating the auxiliary electrode.

According to one embodiment of the present application, the step of forming the strapping hole on the auxiliary electrode further includes:
sequentially depositing a first anode material layer, a second anode material layer, and a third anode material layer on a side of the source-drain electrode layer away from the substrate;
etching the first anode material layer, the second anode material layer, and the third anode material layer to form the anode, and at the same time, etching an initial strapping hole portion of the auxiliary electrode and formed the strapping hole on a basis of the initial strapping hole.

According to one embodiment of the present application, in the step of forming the strapping hole on the auxiliary electrode, an Ag acid etching method is used to etch the first anode material layer, the second anode material layer, the third anode material layer, and the auxiliary electrode.

According to one embodiment of the present application, an activity of the first conductive layer is weaker than an activity of the second conductive layer, and wherein an activity of the third conductive layer is weaker than the activity of the second conductive layer.

According to one embodiment of the present application, the first conductive layer is made of a same material as the third conductive layer, wherein a material of the first conductive layer includes metal alloy, and wherein a material of the second conductive layer is made of metal.

According to one embodiment of the present application, a material of the first conductive layer is molybdenum titanium alloy, and wherein a material of the second conductive layer is copper or aluminum.

Advantages of the embodiments of the present application: The embodiments of the present application provide a display panel and a method of manufacturing the display panel. The display panel includes a driving circuit layer, a common layer, and a cathode layer stacked on a substrate. An auxiliary cathode is disposed in the driving circuit layer of the display panel, at the same time, a strapping hole is disposed on the auxiliary cathode. By utilizing the strapping hole, the common layer can be disconnected at the strapping hole, the cathode layer can extend into the strapping hole and contact with a side of the conductive structure close to the substrate, and the situation of voltage drop can be improved. Compare with the prior art, the present application does not need to provide isolation columns, and the auxiliary cathode can be simultaneously manufactured and formed by using a manufacturing process of the driving circuit layer, thereby reducing a difficulty of a manufacturing process and improving a production efficiency.

### DESCRIPTION OF FIGURES

In order to more clearly illustrate the embodiments or technical solutions in the prior art, the following briefly introduces the accompanying figures that need to be used in the description of the embodiments or the prior art. Obviously, the figures in the following description are only some embodiments of the application, and for those of ordinary skill in the art, other figures can also be obtained from these figures without any inventive steps.
FIG. 1 is a schematic diagram of a stacked structure of a first display panel provided by one embodiment of the present application.
FIG. 2 is an enlarged schematic diagram of place A of FIG. 1 provided by the embodiment of the present application.
FIG. 3 is a schematic diagram of a structure of an auxiliary electrode provided in the embodiment of the present application.
FIG. 4 is a schematic diagram of a stacked structure of a second display panel provided by one embodiment of the present application.
FIG. 5a to FIG. 5f are schematic flowcharts of a method of manufacturing a display panel provided by one embodiment of the present application.

### DETAILED DESCRIPTION OF EMBODIMENTS

The following descriptions of the various embodiments refer to the accompanying figures to illustrate specific embodiments in which the present application may be practiced. Directional terms mentioned in the present application, such as "upper", "lower", "front", "rear", "left", "right", "inner", "outer", "side", etc., are only for reference additional schema orientation. Therefore, the directional terms used are used to describe and understand the present application, rather than to limit the present application. In the figures, structurally similar elements are denoted by the same reference numerals.

The present application will be further described below with reference to the accompanying figures and specific embodiments.

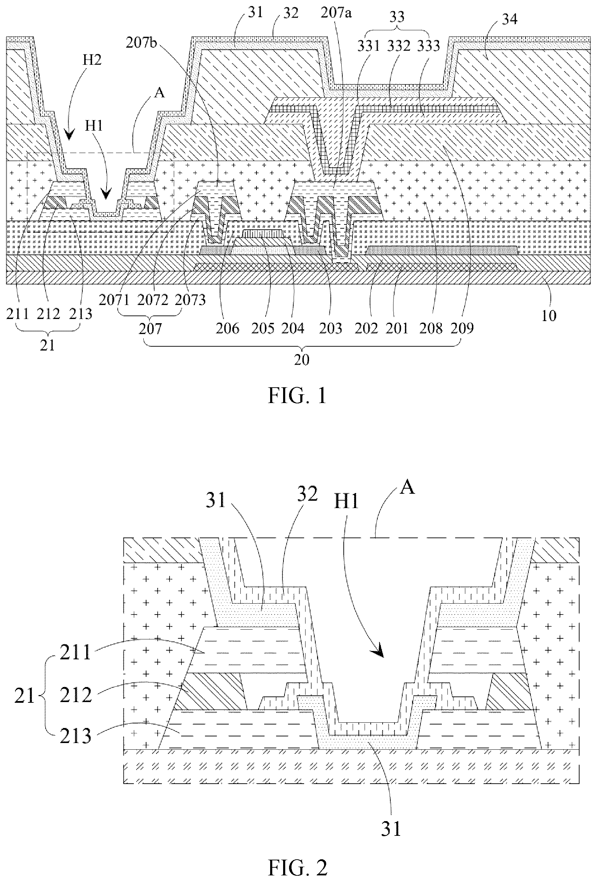

One embodiment of the present application provides a display panel. As shown in FIG. 1, FIG. 1 is a schematic diagram of a stacked structure of the first display panel provided by the embodiment of the present application. The display panel includes a substrate 10, a driving circuit layer 20, a common layer 31, and a cathode layer 32.

The driving circuit layer 20 is disposed on the substrate 10. It should be noted that, being disposed on the substrate 10 may refer to direct contact with the substrate 10, or may refer to indirect contact with the substrate 10.

The common layer 31 is disposed on a side of the driving circuit layer 20 away from the substrate 10, and the cathode layer 32 is disposed on a side of the common layer 31 away from the driving circuit layer 20.

In this embodiment of the present application, the common layer 31 may include, but is not limited to, a hole injection layer, a hole transport layer, an electron transport layer, and an electron injection layer that are stacked in layers. The display panel may also include an organic light-emitting material layer. The organic light-emitting material layer may be disposed between the hole transport layer and the electron transport layer.

An auxiliary electrode 21 is disposed in the driving circuit layer 20. The auxiliary electrode 21 includes a multi-layer stacking conductive structure. The auxiliary electrode 21 is provided with a strapping hole H1. The common layer 31 is disconnected at the strapping hole H1. The cathode layer 32 extends into the strapping hole H1 and in contact with a side of the conductive structure of the auxiliary electrode 21 close to the substrate 10.

It should be noted that, due to a high thickness of the cathode layer of the metal material in the conventional organic light emitting diode display panel, a square resistance is large, the current and voltage drop is serious, and the display panel has obvious uneven brightness. In the embodiment of the present application, by disposing a strapping hole H1 on the auxiliary electrode 21, the common layer 31 is disconnected at the strapping hole H1, and the cathode layer 32 can be in contact to a side of the conductive structure of the auxiliary electrode 21 close to the substrate 10 by the strapping hole H1, to form a circuit structure in parallel with the auxiliary electrode 21. Since a resistance of the auxiliary electrode 21 is relatively small, the resistance of the cathode layer 32 can be reduced when the display panel is powered on, thereby reducing a current and voltage drop, thereby improving a brightness uniformity of the display panel.

In the embodiment of the present application, by disposing the auxiliary electrode 21 in the driving circuit layer 20, the manufacturing process of the driving circuit layer 20 can be used to simultaneously manufacture and form the auxiliary electrode 21. By the strapping hole H1 formed in the auxiliary electrode 21, the common layer 31 can be disconnected at the strapping hole H1, so that an effect of strapping the cathode layer 32 and the auxiliary electrode 21 can be realized, and there is no need to provide isolation columns at the same time, which can reduce a difficulty of the manufacturing process and improve the production efficiency.

Further, the auxiliary electrode 21 includes a first conductive structure 211, a second conductive structure 212, and a third conductive structure 213.

The second conductive structure 212 is disposed on a side of the first conductive structure 211 close to the substrate 10, and the third conductive structure 213 is disposed on a side of the second conductive structure 212 close to the substrate 10.

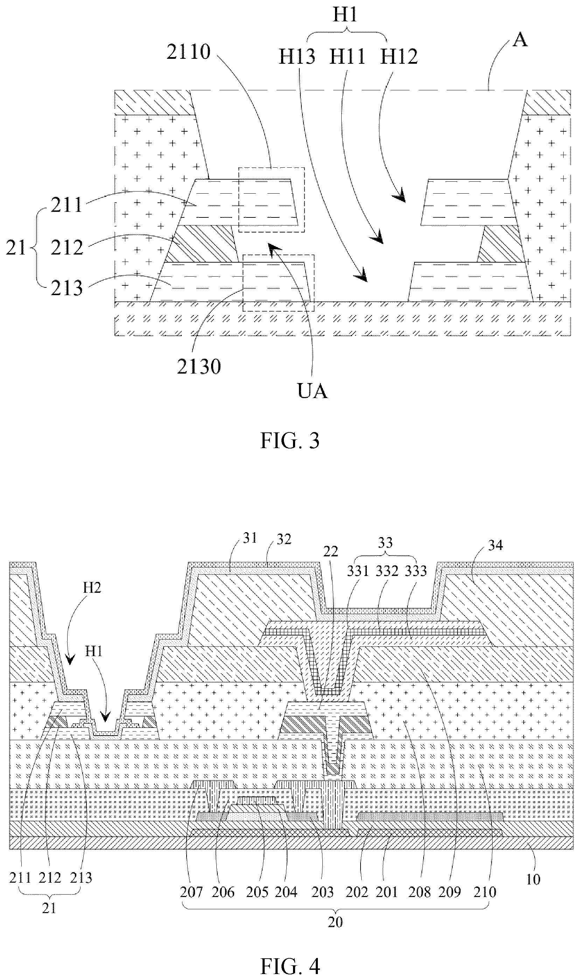

Referring to FIG. 2 and FIG. 3, FIG. 2 is an enlarged schematic view of the position A in FIG. 1 provided by one embodiment of the present application, and FIG. 3 is a schematic structural diagram of an auxiliary electrode provided by one embodiment of the present application. The strapping hole H1 includes a first opening H11 and a second opening H12 are connected. The first opening H11 is formed in the first conductive structure 211, and the second opening H12 is formed in the second conductive structure 212.

The common layer 31 is disconnected at the first opening H11, and the cathode layer 32 is continuously arranged at the first opening H11 and the second opening H12, and extends into the second opening H12 and in contact with the third conductive structure 213.

The strapping hole H1 further includes a third opening H13 communicating with the second opening H12, and the third opening H13 is formed in the third conductive structure 213.

As shown in FIG. 2 and FIG. 3, a portion of the common layer 31 is deposited and formed on a bottom of the third opening H13, and another portion of the common layer 31 is deposited and formed on the first conductive structure 211. The portion of the common layer 31 positioned at the bottom of the third opening H13 is disconnected from the portion of the common layer 31 positioned on the first conductive structure 211.

The cathode layer 32 is continuously arranged at the first opening H11 and the second opening H12, and extends into the second opening H12 and in contact with a side of the third conductive structure 213 away from the substrate 10 exposed by the second opening H12, and also covers the portion of the common layer 31 positioned at the bottom of the third opening H13.

Further, a size of the first opening H11 is smaller than a size of the second opening H12, and a size of the third opening H13 is smaller than the size of the second opening H12.

It should be noted that, the size of the first opening H11 may refer to a width of the first opening H11 in the cross-sectional view shown in FIG. 3. When the first opening H11 is circular, the size of the first opening H11 may refer to a diameter of the first opening H11. For the meaning of other opening sizes, reference may be made to the size of the first opening H11, which will not be repeated here.

As shown in FIG. 3, an inner periphery of the first conductive structure 211 protrudes from an inner periphery of the second conductive structure 212, and an inner periphery of the third conductive structure 213 protrudes from the inner periphery of second conductive structure 212.

Further, the first conductive structure 211 includes a first protrusion 2110 protruding from the inner periphery of the second conductive structure 212, and the third conductive structure 213 includes a second protrusion 2130 protruding from the inner periphery of the second conductive structure 212.

An undercut space UA is formed between the first protrusion 2110, the second protrusion 2130, and an inner side wall of the second conductive structure 212. The cathode layer 32 can extend into the undercut space UA inside and in contact with a surface of a side of the second protrusion 2130 close to the first conductive structure 211.

Further, the driving circuit layer 20 may include, but is not limited to, a light-shielding layer 201, a buffer layer 202, an active layer 203, a gate insulating layer 204, a gate metal layer 205, an interlayer dielectric layer 206, a source-drain electrode layer 207, a protective layer 208, and a planarization layer 209 on the substrate 10.

Thicknesses of the protective layer 208 and the planarization layer 209 are both greater than or equal to 1 micrometer and less than or equal to 4 micrometers. For example, a thickness of the protective layer 208 may be 1µm, 2µm, 3µm or 4µm, and a thickness of the planarization layer 209 may be 1µm, 2µm, 3µm or 4µm. The thickness of the protective layer 208 may be equal to or different from the thickness of the planarization layer 209, which is not limited here.

The display panel further includes an anode 33 disposed on a side of the planarization layer 209 away from the substrate 10, a pixel definition layer 34 disposed on a side of the planarization layer 209 away from the substrate 10 and covering the anode 33, wherein the common layer 31 and the cathode layer 32 are stacked on the pixel definition layer 34.

In one embodiment, the auxiliary electrode 21 and the source-drain electrode layer 207 are disposed on a same layer.

As shown in FIG. 2, the auxiliary electrode 21 and the source-drain electrode layer 207 are both disposed on a side of the interlayer dielectric layer 206 away from the substrate 10. The source-drain electrode layer 207 may include a source electrode 207a and a drain electrode 207b. The active layer 203 may include a semiconductor portion in a middle of the active layer 203and conductor portions on both sides of the semiconductor portion. The source electrode 207a and the drain electrodes 207b are respectively connected to the corresponding conductor portions through the through holes of the interlayer dielectric layer 206.

Further, the source-drain electrode layer 207 includes a multi-layer stack of conductive film layers.

In one embodiment, the source-drain electrode layer 207 may include a first conductive layer 2071, a second conductive layer 2072, and a third conductive layer 2073. The second conductive layer 2072 is disposed between the first conductive layer 2071 and the third conductive layer 2073. The first conductive layer 2071 is disposed on a side of the third conductive layer 2073 away from the substrate 10.

The first conductive structure 211 of the auxiliary electrode 21 is made of a same material as the first conductive layer 2071 of the source-drain electrode layer 207. The second conductive structure 212 of the auxiliary electrode 21 is made of a same material as the second conductive layer 2072 of the source-drain electrode layer 207. The third conductive structure 213 of the auxiliary electrode 21 is made of a same material as the third conductive layer 2073 of the source-drain electrode layer 207. In this way, the auxiliary electrode 21 can be simultaneously manufactured and formed by using a manufacturing process of the source-drain electrode layer 207, so that the manufacturing process and mask required for manufacturing the auxiliary electrode 21 alone can be omitted, thereby simplifying the manufacturing process of the display panel, and reducing production costs.

In addition, arranging the auxiliary electrode 21 and the source-drain electrode layer 207 on a same layer can also prevent the auxiliary electrode 21 from contacting a water-absorbing photoresist material, thereby reducing a risk of encapsulation failure.

Further, an activity of the first conductive structure 211 is weaker than an activity of the second conductive structure 212, and an activity of the third conductive structure 213 is weaker than that of the second conductive structure 212.

A timing rate of the second conductive structure 212 with strong activity is higher than timing rates of the first conductive structure 211 and the third conductive structure 213 when the auxiliary electrode 21 is etched, so as to be formed in the undercut space UA.

Further, the first conductive structure 211 is made of a same material as the third conductive structure 213, a material of the first conductive structure 211 includes metal alloy, and a material of the second conductive structure 212 made of metal.

For example, the materials of the first conductive structure 211 and the third conductive structure 213 are both molybdenum titanium alloy (MoTi), and the material of the second conductive structure 212 is copper (Cu) or aluminum (Al).

In one embodiment, the auxiliary electrode 21 is disposed on a side of the source-drain electrode layer 207 away from the substrate 10.

As shown in FIG. 4, FIG. 4 is a schematic structural diagram of a second type of display panel provided by one embodiment of the present application. It should be noted that a structure of the display panel shown in FIG. 4 is substantially the same as a structure of the display panel shown in FIG. 1, the difference lies in different positions of the film layers provided by the auxiliary electrodes 21.

In the embodiment shown in FIG. 4, a second interlayer dielectric layer 210 is provided on a side of the source-drain electrode layer 207 away from the substrate 10, and the auxiliary electrode 21 is provided on a side of the second dielectric layer 210 facing away from the substrate 10.

A conductive electrode 22 is further provided on a side of the second interlayer dielectric layer 210 away from the substrate 10. The conductive electrode has the same multi-layer conductive structure as the auxiliary electrode 21. An anode 33 is connected to the conductive electrode 22 through a through hole penetrating the planarization layer 209 and the protective layer 208, and the conductive electrode is connected to the drain electrode through a through hole penetrating the second interlayer dielectric layer 210.

Further, the driving circuit layer 20 is provided with an auxiliary strapping hole H2. The auxiliary strapping hole H2 penetrates the planarization layer 209 and the protective layer 208, and exposes the auxiliary electrode 21.

As shown in FIG. 1 or FIG. 4, the auxiliary strapping hole H2 penetrates through the pixel definition layer 34, the planarization layer 209, and the protective layer 208, and exposes the auxiliary electrode 21 so as to facilitate the cathode layer 32 can be deposited and formed on the auxiliary electrode 21, and extends into the strapping hole H1 of the auxiliary electrode 21 to strap with the auxiliary electrode 21.

Further, the anode 33 has a multi-layer stack of anode material layers.

In one embodiment, as shown in FIG. 1, the anode 33 includes a first anode material layer 331, a second anode material layer 332, and a third anode material layer 333 which are sequentially stacked on the planarization layer 209. The materials of the first anode material layer 331 and the third anode material layer 333 are both transparent conductive oxide (TCO). The materials of the second anode material layer 332 is metal.

For example, the material of the first anode material layer 331 and the third anode material layer 333 is indium tin oxide (ITO), and the material of the second anode material layer 332 is silver (Ag).

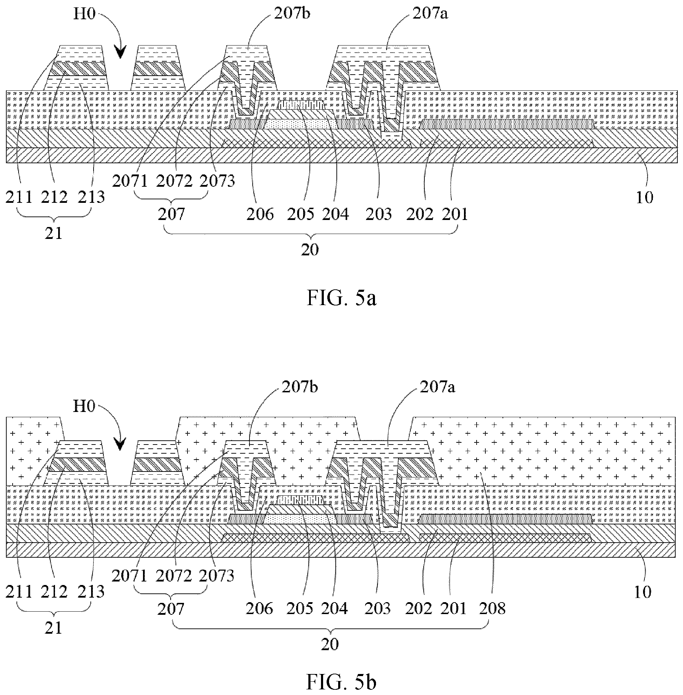

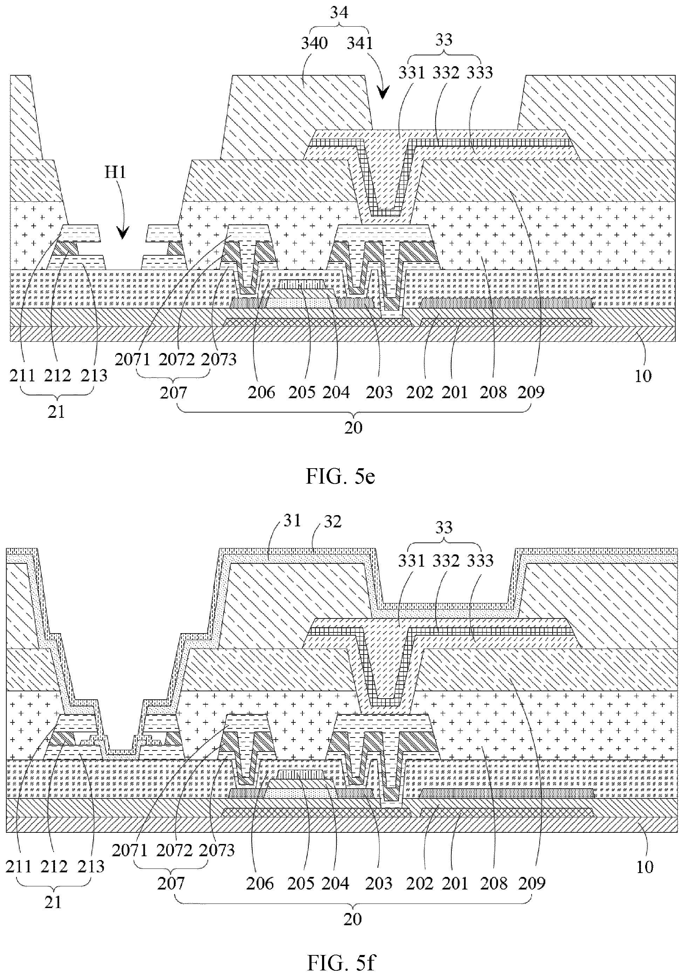

According to the display panels provided by the above embodiments of the present application, the embodiments of the present application further provide a method of manufacturing the display panel provided by the above embodiments, as shown in FIGs. 5a to 5f. FIGs. 5a to 5f are schematic flowcharts of a method of manufacturing a display panel provided by one embodiment of the present application, the method of manufacturing the display panel includes:
Step S10: forming a driving circuit layer 20 on the substrate 10, wherein an auxiliary electrode 21 is disposed in the driving circuit layer 20, and wherein the auxiliary electrode 21 includes a multi-layer stacking conductive structure;
Step S20: forming a strapping hole on the auxiliary electrode;
Step S30: forming a common layer on a side of the driving circuit layer away from the substrate, wherein the common layer is disconnected at the strapping hole; and
Step S40: forming a cathode layer on a side of the common layer facing away from the driving circuit layer, wherein the cathode layer extends into the strapping hole and is in contact with a side of the conductive structure close to the substrate.

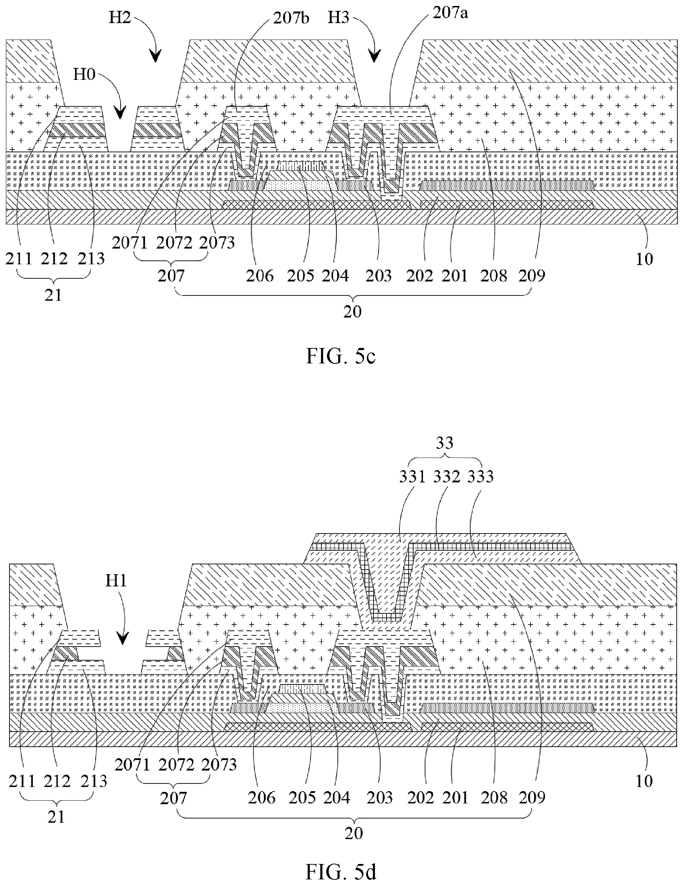

Please refer to FIG. 5a, FIG. 5b and FIG. 5c, the step 10 may include:
Step S101: forming a light-shielding layer 201, a buffer layer 202, an active layer 203, a gate insulating layer 204, a gate metal layer 205, and an interlayer dielectric layer 206 on the substrate 10 in sequence;
Step S102: forming a source-drain electrode layer 207 on the interlayer dielectric layer 206, wherein the source-drain electrode layer 207 includes a first conductive layer 2071, a second conductive layer 2072, and a third conductive layer 2073 that are stacked in sequence;
Step S103: performing a patterning process on the source-drain electrode layer 207 to form a source electrode 207a, a drain electrode 207b and the auxiliary electrode 21, wherein the auxiliary electrode 21 is formed with an initial strapping hole H0 penetrating the auxiliary electrode 21;
Step S104: forming a protective layer 208 on the interlayer dielectric layer 206, and etching the protective layer 208 to expose the auxiliary electrode 21, the initial strapping hole H0 and the source electrode 207a;
Step S105: forming a planarization layer 209 on the protective layer 208, etching the planarization layer 209 to form an auxiliary strapping hole H2 and an anode contact hole H3, wherein the auxiliary strapping hole H2 exposes the auxiliary electrode 21 and the initial strapping hole H0, and wherein the anode contact hole H3 exposes the source electrode 207a.

In this embodiment of the present application, as shown in FIG. 5a, the auxiliary electrode 21 may include a third conductive structure 213, a second conductive structure 212, and a first conductive structure 211 that are stacked in sequence. The initial strapping hole H0 penetrates through the first conductive structure 211, the second conductive structure 212, and the third conductive structure 213, wherein a size of the initial strapping hole H0 gradually decreases from a terminal away from the substrate 10 to a terminal close to the substrate 10.

Referring to FIG. 5d, the steps of step S20 include:
Step S201: sequentially depositing a first anode material layer 331, a second anode material layer 332, and a third anode material layer 333 on the planarization layer 209;
Step S202: etching the first anode material layer 331, the second anode material layer 332, and the third anode material layer 333 by using an Ag acid etching method to form the anode 33, and at the same time, etching the auxiliary electrode 21 and formed the strapping hole H1 on a basis of the initial strapping hole H0.

It should be noted that, by adjusting the Ag acid etching process, the auxiliary electrode 21 can be etched while the first anode material layer 331, the second anode material layer 332, and the third anode material layer 333 are being etched, therefore the mask required for separately etching the auxiliary electrode 21 to form the strapping hole H1 can be omitted.

With reference to FIG. 3, since the activity of the second conductive structure 212 in the auxiliary electrode 21 is higher than the activities of the first conductive structure 211 and the third conductive structure 213, the etching rate of the second conductive structure 212 is higher than the etching rate of the first conductive structure 211 and the third conductive structure 213, so that the first conductive structure 211 can form a first protrusion 2110 protruding from an inner periphery of the second conductive structure 212, and the third conductive structure 213 can form a second protrusion 2130 protruding from an inner periphery of the second conductive structure 212. An undercut space UA is formed between the first protrusion 2110, the second protrusion 2130, and an inner side wall of the second conductive structure 212.

Referring to FIGs. 5e to 5f, in the step S30, before forming the common layer 31, a pixel definition layer 34 needs to be formed on the planarization layer 209, and the pixel definition layer 34 is etched to form a plurality of dam 340. The plurality of dam 340 encloses the pixel opening 341 and the opening for exposing the auxiliary electrode 21.

In the step S30, the common layer 31 can be manufactured by a whole surface evaporation method. Since there is an undercut space UA at the strapping hole H1, the common layer 31 would be broken at the strapping hole H1, and cannot completely cover the auxiliary electrode 21.

In some other embodiments, the cathode layer 32 can also be formed by sputtering.

In the step S40, the cathode layer 32 can be manufactured by evaporation on the entire surface. The evaporation angle different from the common layer 31 can be controlled when the cathode layer 32 is formed by evaporation, to ensure that the cathode layer 32 can continuously form a film at the strapping hole H1, and extend into the undercut space UA of the strapping hole H1 to contact the third conductive structure 213.

Beneficial effects of the embodiments of the present application: The embodiments of the present application provide a display panel and a method of manufacturing the display panel. The display panel includes a driving circuit layer, a common layer, and a cathode layer stacked on a substrate. An auxiliary cathode is disposed in the driving circuit layer of the display panel, at the same time, a strapping hole is disposed on the auxiliary cathode. By utilizing the strapping hole, the common layer can be disconnected at the strapping hole, and the cathode layer can extend into the strapping hole and contact with a side of the conductive structure close to the substrate, the situation of voltage drop can be improved. Compared with the prior art, the present application does not need to provide isolation columns, and the auxiliary cathode can be simultaneously manufactured and formed by using a manufacturing process of the driving circuit layer, thereby reducing a difficulty of a manufacturing process and improving a production efficiency.

To sum up, although the present application discloses the above-mentioned preferred embodiments, the above-mentioned preferred embodiments are not intended to limit the present application. Those of ordinary skill in the art can make various changes and modifications without departing from the spirit and scope of the present application. Therefore, a protection scope of the present application is based on a scope defined by the claims.

## Claims

1. A display panel, comprising:
a substrate;
a driving circuit layer disposed on the substrate, wherein an auxiliary electrode is disposed in the driving circuit layer;
a common layer disposed on a side of the driving circuit layer away from the substrate; and
a cathode layer disposed on a side of the common layer away from the driving circuit layer;
wherein the auxiliary electrode comprises a multi-layer stacking conductive structure, wherein the auxiliary electrode is provided with a strapping hole, wherein the common layer is disconnected at the strapping hole, and wherein the cathode layer extends into the strapping hole and in contact with a side of the conductive structure close to the substrate.

2. The display panel according to claim 1, wherein the auxiliary electrode comprises:
a first conductive structure;
a second conductive structure disposed on a side of the first conductive structure close to the substrate; and
a third conductive structure disposed on a side of the second conductive structure close to the substrate;
the strapping hole comprises a first opening disposed in the first conductive structure and a second opening disposed in the second conductive structure;
wherein the common layer is disconnected at the first opening, and wherein the cathode layer is continuously arranged at the first opening and the second opening, and extends into the second opening and in contact with the third conductive structure.

3. The display panel according to claim 2, wherein a size of the first opening is smaller than a size of the second opening.

4. The display panel according to claim 3, wherein the strapping hole comprises a third opening disposed in the third conductive structure, wherein a size of the third opening is smaller than the size of the second opening.

5. The display panel according to claim 4, wherein an inner periphery of the first conductive structure protrudes from an inner periphery of the second conductive structure, wherein an inner periphery of the third conductive structure protrudes from the inner periphery of the second conductive structure.

6. The display panel according to claim 5, wherein the first conductive structure comprises a first protrusion protruding from the inner periphery of the second conductive structure, wherein the third conductive structure comprises a second protrusion protruding from the inner periphery of the second conductive structure, wherein an undercut space is formed between the first protrusion, the second protrusion, and an inner sidewall of the second conductive structure, and wherein the cathode layer extends into the undercut space and is in contact with the second protrusion.

7. The display panel according to claim 2, wherein the driving circuit layer comprises a source-drain electrode layer, wherein the source-drain electrode layer comprises a source electrode and a drain electrode, and wherein the auxiliary electrode and the source-drain electrode layer are set on a same layer.

8. The display panel according to claim 7, wherein the driving circuit layer comprises a protective layer and a planarization layer, wherein the protective layer is disposed on a side of the auxiliary electrode away from the substrate, and wherein the planarization layer is disposed on a side of the protective layer away from the auxiliary electrode;
wherein the driving circuit layer is provided with an auxiliary strapping hole, and wherein the auxiliary strapping hole penetrates the planarization layer and the protective layer, and exposes the auxiliary electrode.

9. The display panel according to claim 2, wherein the driving circuit layer comprises a source-drain electrode layer, wherein the source-drain electrode layer comprises a source electrode and a drain electrode, and wherein the auxiliary electrode is disposed on a side of the source-drain electrode layer away from the substrate.

10. The display panel according to claim 9, wherein the driving circuit layer comprises a protective layer and a planarization layer, wherein the protective layer is disposed on a side of the auxiliary electrode away from the substrate, and wherein the planarization layer is disposed on a side of the protective layer away from the auxiliary electrode;
wherein the driving circuit layer is provided with an auxiliary strapping hole, and wherein the auxiliary strapping hole penetrates the planarization layer and the protective layer, and exposes the auxiliary electrode.

11. The display panel according to claim 2, wherein an activity of the first conductive structure is weaker than an activity of the second conductive structure, and wherein an activity of the third conductive structure is weaker than the activity of the second conductive structure.

12. The display panel according to claim 11, wherein the first conductive structure is made of a same material as the third conductive structure, wherein a material of the first conductive structure comprises metal alloy, and wherein a material of the second conductive structure is made of metal.

13. The display panel according to claim 12, wherein a material of the first conductive structure is molybdenum titanium alloy, and wherein a material of the second conductive structure is copper or aluminum.

14. A method of manufacturing a display panel, comprising:
forming a driving circuit layer on the substrate, wherein an auxiliary electrode is disposed in the driving circuit layer, and wherein the auxiliary electrode comprises a multi-layer stacking conductive structure;
forming a strapping hole on the auxiliary electrode;
forming a common layer on a side of the driving circuit layer away from the substrate, wherein the common layer is disconnected at the strapping hole; and
forming a cathode layer on a side of the common layer facing away from the driving circuit layer, wherein the cathode layer extends into the strapping hole and is in contact with a side of the conductive structure close to the substrate.

15. The method of manufacturing the display panel according to claim 14, wherein the step of forming the driving circuit layer on the substrate, wherein the auxiliary electrode is disposed in the driving circuit layer, and wherein the auxiliary electrode comprises the multi-layer stacking conductive structure further comprises:
forming a source-drain electrode layer on the substrate, wherein the source-drain electrode layer comprises a first conductive layer, a second conductive layer, and a third conductive layer stacked on the substrate in sequence;
patterning the source-drain electrode layer to form a source electrode, a drain electrode, and the auxiliary electrode, wherein the auxiliary electrode is formed with an initial strapping hole penetrating the auxiliary electrode.

16. The method of manufacturing the display panel according to claim 15, wherein the step of forming the strapping hole on the auxiliary electrode further comprises:
sequentially depositing a first anode material layer, a second anode material layer, and a third anode material layer on a side of the source-drain electrode layer away from the substrate;
etching the first anode material layer, the second anode material layer, and the third anode material layer to form the anode, and at the same time, etching an initial strapping hole portion of the auxiliary electrode and formed the strapping hole on a basis of the initial strapping hole.

17. The method of manufacturing the display panel according to claim 16, wherein in the step of forming the strapping hole on the auxiliary electrode, an Ag acid etching method is used to etch the first anode material layer, the second anode material layer, the third anode material layer, and the auxiliary electrode.

18. The method of manufacturing the display panel according to claim 16, wherein an activity of the first conductive layer is weaker than an activity of the second conductive layer, and wherein an activity of the third conductive layer is weaker than the activity of the second conductive layer.

19. The method of manufacturing the display panel according to claim 18, wherein the first conductive layer is made of a same material as the third conductive layer, wherein a material of the first conductive layer comprises metal alloy, and wherein a material of the second conductive layer is made of metal.

20. The method of manufacturing the display panel according to claim 19, wherein a material of the first conductive layer is molybdenum titanium alloy, and wherein a material of the second conductive layer is copper or aluminum.
